# EUROPÄISCHE PATENTSCHRIFT

(11) **EP 0 890 198 B1**
(45) Veröffentlichungstag und Bekanntmachung des Hinweises auf die Patenterteilung: **15.09.1999**
(21) Anmeldenummer: 97918040.3
(22) Anmeldetag: 19.03.1997
(51) Int. Cl.: H01R 9/07

(54) **ANORDNUNG ZWEIER VONEINANDER LÖSBARER FLACHLEITUNGEN UND ANSCHLUSSANORDNUNG FÜR DEN ANSCHLUSS EINER FLACHLEITUNG**
ARRANGEMENT OF TWO DISCONNECTABLE FLAT CONDUCTORS AND A CONNECTION UNIT FOR CONNECTING A FLAT CONDUCTOR
AGENCEMENT DE DEUX CONDUCTEURS PLATS POUVANT ETRE SEPARES ET DISPOSITIF DE CONNEXION D'UN CONDUCTEUR PLAT

(30) Priorität: 28.03.1996 DE 19612415
(43) Veröffentlichungstag der Anmeldung: 13.01.1999
(73) Patentinhaber: Océ Printing Systems GmbH, 85586 Poing (DE)
(72) Erfinder: MORRIS, Edward, D-85435 Erding (DE); EIBL, Martin, D-85669 Reithofen (DE); PACHONIK, Klaus, D-82024 Taufkirchen (DE); KÜRMEIER, Christian, D-80339 München (DE); VANEK, Wenzel, D-85540 Haar (DE)
(74) Vertreter: Schaumburg, Thoenes & Thurn
(86) Internationale Anmeldenummer: DE9700566
(87) Internationale Veröffentlichungsnummer: WO9737403

(56) Entgegenhaltungen:
- EP-A- 0 426 553
- DE-A- 3 438 949
- JP-A- 62 281 282
- US-A- 4 647 125
- PATENT ABSTRACTS OF JAPAN vol. 095, no. 006, 31.Juli 1995 & JP 07 061039 A (OKI ELECTRIC IND CO LTD), 7.März 1995,

## Beschreibung

Die Erfindung betrifft eine Verbindungsanordnung zum Verbinden zweier voneinander lösbarer Flachleitungen, bei der die Flachleitungen Teil einer elektrischen Verbindung zwischen einer Stromversorgung und einer Belichtungsvorrichtung in einem elektrografischen LED-Drucker oder LED-Kopiergerät sind. Elektrische Verbindungen zu der Belichtungsvorrichtung eines LED-Druckers sind in der Zusammenfassung der Japanischen Offenlegungsschrift JP 07 061039 erläutert; vgl. Patent Abstracts of Japan Volume 095, Nr. 006, 31. Juli 1995, sowie DE 34 38 949 A1.

In der europäischen Patentanmeldung mit dem Aktenzeichen 95 107 809.6 ist eine elektrische Verbindung zwischen einer Stromversorgung und einer Belichtungsvorrichtung in einem elektrografischen LED-Drucker beschrieben. Das Druckprinzip eines LED-Druckers kann dieser Druckschrift ebenfalls entnommen werden. Beim Druck einer Zeile des Druckbildes wird für jeden Bildpunkt der Zeile eine lichtemittierende Diode (LED) angesteuert. Üblicherweise ist die Druckdichte der Bildpunkte so hoch, daß mehrere tausend Leuchtdioden nebeneinander angeordnet sind. Jede Leuchtdiode benötigt einen Strom von einigen mA, um einen schwarzen Bildpunkt zu erzeugen. Aufgrund der Vielzahl der Leuchtdioden und der beim Druck verschiedener Zeilen stark schwankenden Anzahl von schwarzen Bildpunkten kommt es zu hohen Stromstößen auf der Verbindungsleitung und in deren Folge zu einem Überschreiten oder Unterschreiten der Betriebsspannung. Diese Schwankungen der Betriebsspannung wirken sich negativ auf den Druck der nachfolgenden Zeile aus, da ungleichmäßige Belichtungen die Folge sind.

Eine bekannte Gegenmaßnahme besteht darin, wie in der erwähnten Druckschrift beschrieben, eine sogenannte Rampenschaltung zu verwenden, die den Stromfluß regelt. Dies stellt jedoch eine aufwendige Lösung dar, die vor allem bei hohen Druckgeschwindigkeiten unbefriedigende Ergebnisse liefert.

Zum Durchführen von Wartungsarbeiten ist es unbedingt erforderlich, daß die elektrische Verbindung zwischen der Stromversorgung und der Belichtungsvorrichtung lösbar ist, d.h. ohne Zerstörung der Verbindungsvorrichtung durchgeführt werden kann. Dies muß beim Entwurf der Verbindung berücksichtigt werden.

In einem Produktkatalog Nr. 714-8 der AMP Inc., Elizabeth-town, Pennsylvania USA, "A-MP CAPITRON POWER DISTRIBUTION SYSTEMS", Druckvermerk 14.8-10M-PP-7.68, 1968, ist eine Flachleitung eines Leistungs-Verteilungs-Systems beschrieben, welche mehrere Metallstreifen zur Stromführung hat, die voneinander isoliert sind. Die Enden der Metallstreifen ragen über die Isolation hinaus, um weitere Anschlüsse, beispielsweise Leiterplatten, anschließen zu können. Die beschriebene Flachleitung ist für Anwendungen im Bereich hoher Übertragungsgeschwindigkeiten und hoher Informationsdichte vorgesehen.

Aus der DE-A-15 90 81 ist ein Flachleiter-Kabelbaum bekannt, dessen Flachleitungen Anschlußstücke haben. Die Flachleitungen sind durch eine Isolierung voneinander getrennt. Die Anschlußstücke sind quer zum Verlauf der Flachleitungen herausgeführt und dienen jeweils als Teil einer Schraubverbindung.

In der EP-A-0 426 553 wird ein zur Übertragung von Hochspannung verwendetes Verbindungssystem erläutert, bei dem eine zum Verbindungssystem führende Flachleitung mit einem Steckereinsatz verbunden ist. Das andere Ende des Steckereinsatzes wird an einer weiteren Verbindungsstelle mit einer zweiten zum Verbindungssystem führenden Flachleitung verbunden.

Außerdem erläutert die japanische Offenlegungsschrift JP 62281282 eine Verbindungsanordnung für eine geschirmte Flachleitung.

Aufgabe der Erfindung ist es, für einen LED-Drucker eine Stromversorgung anzugeben, die eine hohe Druckqualität gewährleistet.

Diese Aufgabe wird durch eine Anordnung gemäß Anspruch 1 gelöst. Weiterbildungen sind in den Unteransprüchen angegeben.

Bei der erfindungsgemäßen Anordnung enthält die erste Flachleitung einen untersten Metallstreifen und mindestens eine darüberliegende Streifenanordnung aus einem weiteren Metallstreifen und einem Isolierstreifen, der den weiteren Metallstreifen vom darunterliegenden Metallstreifen isoliert und zumindest abschnittsweise parallel zu diesem anordnet. Außerdem ist die erste Flachleitung nahe der Verbindungsstelle mit der zweiten Flachleitung derart ausgebildet, daß der darunter liegende Metallstreifen über den Isolator hinausragt. Die zweite Flachleitung hat den gleichen Aufbau wie die erste Flachleitung. An der Verbindungsstelle gelangen zumindest der unterste Metallstreifen der ersten Flachleitung mit dem obersten Metallstreifen der zweiten Flachleitung und der oberste Metallstreifen der ersten Flachleitung mit dem untersten Metallstreifen der zweiten Flachleitung in elektrischen Kontakt.

Die Erfindung geht von der Erkenntnis aus, daß die Induktivität der Verbindung zwischen der Stromversorgung und der Belichtungsvorrichtung einen wesentlichen Einfluß auf die Qualität des Druckbildes hat, da durch ihre Größe bei vorgebenen Änderungen der Stromstärke die Änderung der Betriebsspannung bestimmt wird. Kommt es zu Spannungsschwankungen, so erreichen die Leuchtdioden nicht ihre Soll-Leuchtstärke. Dies führt zu optisch wahrnehmbaren Veränderungen im Druckbild. Deshalb werden bei der Erfindung zwei Flachleitungen an einer Verbindungsstelle_miteinander verbunden, die ebenso wie die Flachleituhg eine sehr niedrige Induktivität hat.

Eine niedrige Induktivität der ersten Flachleitung wird dadurch gewährleistet, daß die jeweils einem Spannungspotential zugeordneten Metallstreifen in der Flachleitung einen geringen Abstand voneinander haben, der durch einen zwischen zwei benachbarten Metallstreifen liegenden Isolierstreifen vorgegeben wird. In der Flachleitung werden Metallstreifen verwendet, da diese aufgrund ihrer geringen Steifigkeit in Längsrichtung ein Verbiegen der Flachleitung quer zur Längsrichtung ermöglichen, so daß die Flachleitung im LED-Drucker je nach erforderlichem Leitungsverlauf abgewinkelt werden kann.

Die Erfindung geht weiterhin von der Erkenntnis aus, daß die Induktivität der Verbindung zwischen der Stromversorgung und der Belichtungsvorrichtung auch wesentlich von der Induktivität der Verbindungsstelle mitbestimmt wird. Deshalb wird die zweckmäßige Anordnung der Metallstreifen innerhalb der ersten Flachleitungen bei der Erfindung auch an der Verbindungsstelle im wesentlichen beibehalten, indem die Flachleitung an der Verbindungsstelle dahingehend verändert wird, daß der erste Metallstreifen über den Isolierstreifen und auch über den weiteren Metallstreifen hinausragt, so daß sich eine treppenförmige Anordnung der Metallstreifen an der Verbindungsstelle ergibt.

Die andere Flachleitung hat zumindest an der Verbindungsstelle den gleichen Aufbau. Durch diese Maßnahme wird erreicht, daß die treppenförmigen Abstufungen der beiden Flachleitungen so zueinander angeordnet werden können, daß die Metallstreifen der beiden Flachleitungen, die dem gleichen Potential zugeordnet sind, in elektrischen Kontakt gelangen. Der Abstand zwischen zwei benachbarten Metallstreifen wird auch an der Verbindungsstelle nicht größer als innerhalb der Flachleitungen, so daß die Induktivität der gesamten elektrischen Verbindung zwischen Stromversorgung und Belichtungsvorrichtung eine geringe Induktivität an der Verbindungsstelle ebenso wie in den Flachleitungen hat. Die Folge der geringen Induktivität der elektrischen Verbindung zwischen Stromversorgung und Belichtungsvorrichtung ist, daß auch bei einer hohen Druckauflösung, die durch eine sehr große Zahl von in einer Zeile angeordneten Leuchtdioden erreicht wird, sichtbare ungewollte Verschlechterungen des Druckbildes vermieden werden, wie sie bei einem ungewollten Absinken oder Überhöhen der Betriebsspannung infolge hoher Induktivität der elektrischen Verbindung und gleichzeitiger Stromänderung auftritt, da die niedrige induktivität bei vorgegebenen Stromänderungen zu einer niedrigeren Spannungsänderung führt.

Der Aufbau der Verbindungsstelle ist bei der Erfindung denkbar einfach, da beim Herstellen der Verbindungsleitung lediglich auch die treppenartige Abstufung der Metallstreifen der jeweiligen Verbindungsleitung an der Verbindungsstelle geachtet werden muß.

Durch die Erfindung wird erreicht, daß bei Wartungsarbeiten die Stromversorgung auf einfache Art und Weise von der Belichtungsvorrichtung getrennt werden kann, um z.B. die Stromversorgung oder die Belichtungsvorrichtung auszuwechseln. Trotzdem wird die Induktivität der gesamten Verbindung durch die Verbindungsstelle nicht wesentlich erhöht.

In einem Ausführungsbeispiel der Erfindung überlappen sich in Kontakt stehende Metallstreifen. Durch das Überlappen wird erreicht, daß der elektrische Kontakt zwischen Metallstreifen mit gleichem Potential der beiden Flachleitungen durch einen Druck in Richtung der überlappenden Bereiche verstärkt werden kann.

Ein weiteres Ausführungsbeispiel der Erfindung besteht darin, daß jede der Flachleitungen an der Verbindungsstelle mindestens eine Aufnahme für eine Verbindungsvorrichtung enthält. Die Verbindungsvorrichtung verbindet die beiden Flachleitungen ortsfest miteinander und erhöht den elektrischen Kontakt zwischen Metallstreifen der beiden Leitungen mit gleichem Potential. Eine einfache Variante besteht im Verwenden einer Schraubverbindung, die den elektrischen Kontakt zwischen sich berührenden Metallstreifen erhöht und gleichzeitig eine sichere mechanische Verbindung zwischen den beiden Flachleitungen gewährleistet.

Die Erfindung betrifft weiterhin zwei Anschlußanordnungen für den Anschluß einer Flachleitung mit den Merkmalen des Patentanspruchs 11 bzw. 12. Diese Anschlußanordnungen bieten die Möglichkeit, eine Flachleitung mit niedriger Induktivität an die Anschlußanordnung anzuschließen, ohne daß die Induktivität der gesamten elektrischen Verbindung durch die Anschlußanordnung wesentlich erhöht wird. Eine oder mehrere Anschlußelektroden können bei den Anschlußanordnungen nach der Erfindung massiv ausgeführt werden, so daß sie eine Halterung für die gesamte Anschlußanordnung bilden. Gleichzeitig kann eine der massiven Anschlußelektroden als Masseleitung für einen hohen Stromfluß ausgelegt sein.

Die Erfindung betrifft auch Flachleitungen mit mehr als zwei Metallstreifen, wie sie z.B. für eine Spannungsversorgung mit einem Massepotential, einem positiven Potential und einem negativen Potential notwendig sind. Außerdem muß eine Anschlußstelle bei der Erfindung nicht zwingend am Ende einer Flachleitung angeordnet sein. Es werden auch Flachleitungen verwendet, bei denen die Anschlußstelle nicht an einem der Enden angeordnet ist. In diesem Fall ergibt sich eine Verzweigung der Flachleitungen an der Verbindungsstelle.

Durch die Erfindung wird erreicht, daß bei 3,8 V Betriebsspannung, einem Stromfluß von 100 A und einer Schaltzeit von 5 µs nur eine Spannungsschwankung von etwa 400 mV nach 5 µs verbleibt. Gegenüber Flachleitungen, die nicht gemäß der Erfindung angeordnet sind, ist dieses Ergebnis eine Verbesserung um mindestens den Faktor vier.

Im folgenden werden Ausführungsbeispiele der Erfindung anhand der Zeichnungen erläutert. Dabei zeigen :
- Fig. 1: ein Blockschaltbild mit wesentlichen elektrischen Funktionseinheiten eines LED-Druckers,
- Fig. 2: ein erstes Ausführungsbeispiel mit zwei voneinander lösbaren Flachleitungen,
- Fig. 3: ein zweites Ausführungsbeispiel mit zwei voneinander lösbaren Flachleitungen,
- Fig. 4: ein drittes Ausführungsbeispiel mit einer Anschlußanordnung für den Anschluß einer Flachleitung,
- Fig. 5: ein viertes Ausführungsbeispiel mit einer Anschlußanordnung für den Anschluß einer Flachleitung, und
- Fig. 6: ein fünftes Ausführungsbeispiel mit zwei an einer Verzweigungsstelle voneinander lösbaren Flachleitungen, die jeweils drei Metallstreifen enthalten.

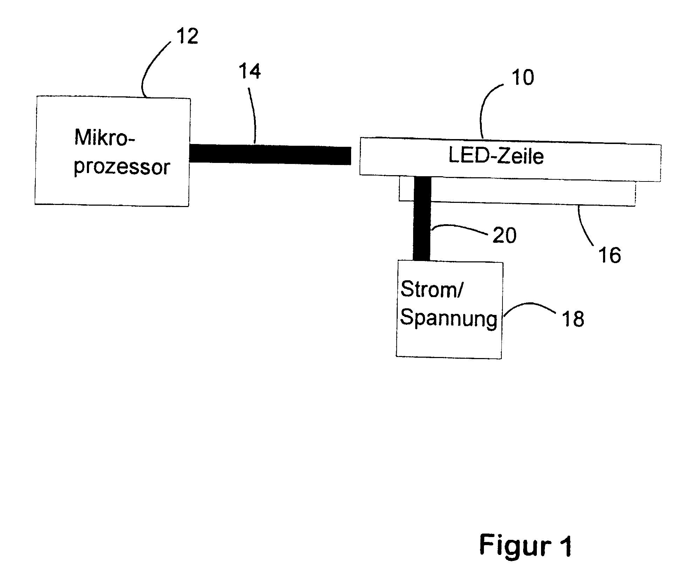

Fig. 1 zeigt ein Blockschaltbild mit ausgewählten elektrischen Funktionseinheiten eines LED-Druckers, der ein Druckbild auf Papier druckt. Eine LED-Belichtungszeile 10 enthält eine sehr große Anzahl von Leuchtdioden (LED), die üblicherweise mehrere tausend Stück beträgt. Die Leuchtdioden sind nebeneinander in einer Zeile angeordnet, so daß innerhalb der Zeile keine mechanische Bewegung zum Belichten einer nicht dargestellten fotoleitenden Schicht ausgeführt werden muß. Die Leuchtdioden müssen die fotoleitende Schicht mit einer vorgegebenen Lichtenergie belichten, damit im Ergebnis ein Druckbild hoher Qualität erreicht wird. Ein Mikroprozessor 12 steuert über ein Bussystem 14 die LED-Belichtungszeile .10 so an, daß das gewünschte Druckbild entsteht. Da beim Drucken aufgrund der Vielzahl von Leuchtdioden eine große Wärmemenge entsteht, ist die LED-Belichtungszeile 10 auf einem Träger 16 angeordnet, der die entstehende Wärme abführt und gleichzeitig Massepotential führt.

Eine Strom-/Spannungsversorgung 18 liefert die notwendige Energie für das Belichten über eine Verbindungsleitung 20 an die LED-Belichtungszeile 10. Obwohl jede Leuchtdiode beim Belichten der fotoleitenden Schicht nur einen relativ geringen Strom im mA-Bereich verbraucht, summiert sich der Stromverbrauch der gesamten LED-Belichtungszeile 10 beim Belichten einer Zeile zu einer Größe von bis zu 100 Ampere. Folgt auf eine vollständig belichtete Zeile z.B. eine vollständig unbelichtete Zeile, so kommt es zu einer Stromschwankung von bis zu 100 Ampère in einer sehr kurzen Zeitspanne, die im Mikrosekunden-Bereich liegt. Somit ergeben sich für die Strom-/Spannungsversorgung 18 und die elektrische Verbindungsleitung 20 erhöhte Anforderungen bezüglich der Induktivität. Um Spannungsschwankungen zu vermeiden, muß die Induktivität insbesondere der elektrischen Verbindungsleitung 20 gering sein. Da außerdem die Strom-/Spannungsversorgung 18 für Wartungsarbeiten von der LED-Belichtungszeile 10 bzw. dem Träger 16 lösbar sein muß, übertragen sich die Anforderungen bezüglich der Induktivität auch auf die Verbindungsstelle zwischen LED-Belichtungszeile 10 und Strom-/Spannungsversorgung 18.

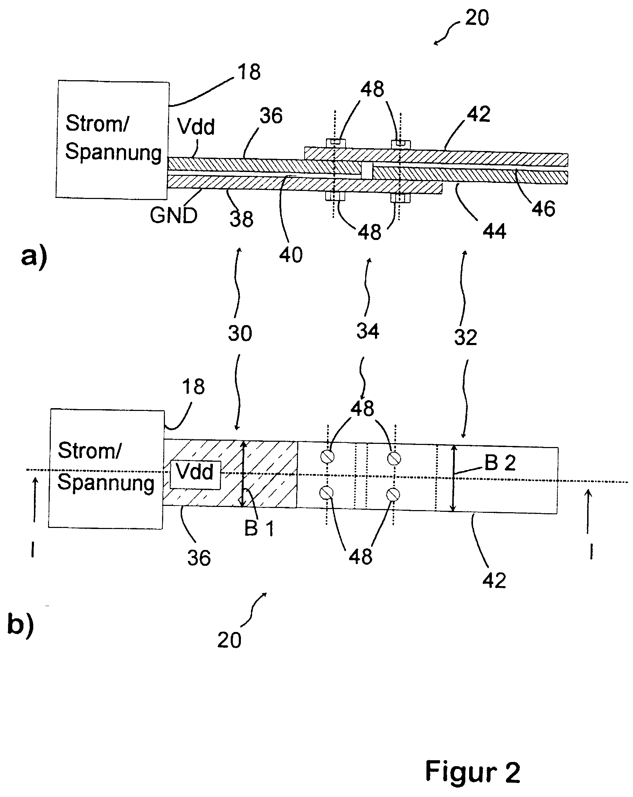

Fig. 2 zeigt ein erstes Ausführungsbeispiel mit einer Anordnung zweier voneinander lösbarer Flachleitungen 30 und 32, die Teil der elektrischen Verbindungsleitung 20 sind. In einem Teil a der Fig. 2 ist eine Schnittdarstellung der beiden Flachleitungen 30 und 32 an einer Verbindungsstelle 34 dargestellt. Der Schnitt wurde entlang einer in Teil 6 der Figur 2 dargestellten Schnittlinie I ausgeführt. Eine erste Flachleitung 30 enthält einen ersten Metallstreifen 3.6 zum Führen eines positiven Potentials Vdd, einen weiteren Metallstreifen 38 zum Führen eines Massepotentials GND und einen Isolierstreifen 40, der die Metallstreifen 36 und 38 voneinander elektrisch isoliert und in einem definierten Zustand zueinander anordnet.

Eine zweite Flachleitung 32 hat im Bereich der Verbindungsstelle 34 im wesentlichen den gleichen Aufbau wie die Flachleitung 30. Sie enthält einen Metallstreifen 42 zum Führen des positiven Potentials Vdd, einen Metallstreifen 44 zum Führen des Massepotentials GND und einen zwischen den Metallstreifen 42 und 44 angeordneten Isolierstreifen 46, der die Metallstreifen 42 und 44 voneinander isoliert und in einem definierten Abstand zueinander anordnet. An der Verbindungsstelle 34 ragt der Metallstreifen 38 der ersten Flachleitung 30 über den Isolatorstreifen 40 und den Metallstreifen 36 hinaus. Ebenso ragt der Metallstreifen 42 der zweiten Flachleitung 32 über den Isolierstreifen 46 und den Metallstreifen 44 hinaus. Dadurch ist es möglich, die Flachleitungen 30 und 32 an der Verbindungsstelle so anzuordnen, daß sich der Metallstreifen 36 und der Metallstreifen 42 an der Verbindungsstelle 34 unmittelbar überlappen und in elektrischen Kontakt gelangen. Ebenso überlappen sich die Metallstreifen 38 und 44 an der Verbindungsstelle 34, wobei die beiden Metallstreifen 38 und 44 in elektrischen Kontakt gelangen.

Der elektrische Kontakt zwischen den Flachleitungen 30 und 32 wird durch eine aus vier Schraubverbindungen 48 bestehende Verbindung erhöht, die sich überlappende Bereiche der Metallstreifen 36, 42 bzw. 38, 44 kraftschlüssig aneinander drückt und die außerdem gewährleistet, daß die Flachleitungen 30 und 32 auf Zugkräfte bzw. Druckkräfte in Längsrichtung beansprucht werden können, ohne daß sich die Verbindung an der Verbindungsstelle 34 löst.

Teil b der Fig. 2 zeigt die Flachleitungen 30 und 32 an der Verbindungsstelle 34 in Draufsicht. Die Flachleitungen 30 und 32 haben jeweils die gleiche Breite B1 bzw. B2 und sind so zueinander angeordnet, daß kein Versatz bezüglich der Breiten B1 und B2 auftritt.

Die Schraubverbindungen 48 sind durch geeignete Maßnahmen von den Metallstreifen 36, 38, 42 bzw. 44 isoliert. Eine Isolierung kann durch das Verwenden von Schraubverbindungen 48 aus Kunststoffmaterial erreicht werden. Alternativ dazu kann eine Isolierung der Schraubverbindung 48 durch das Verwenden von isolierenden Unterlegscheiben im Bereich des Schraubenkopfes und der Mutter sowie durch isolierende Abstandshalter zwischen dem jeweiligen Schraubenkörper und dem betreffenden Metallstreifen erreicht werden.

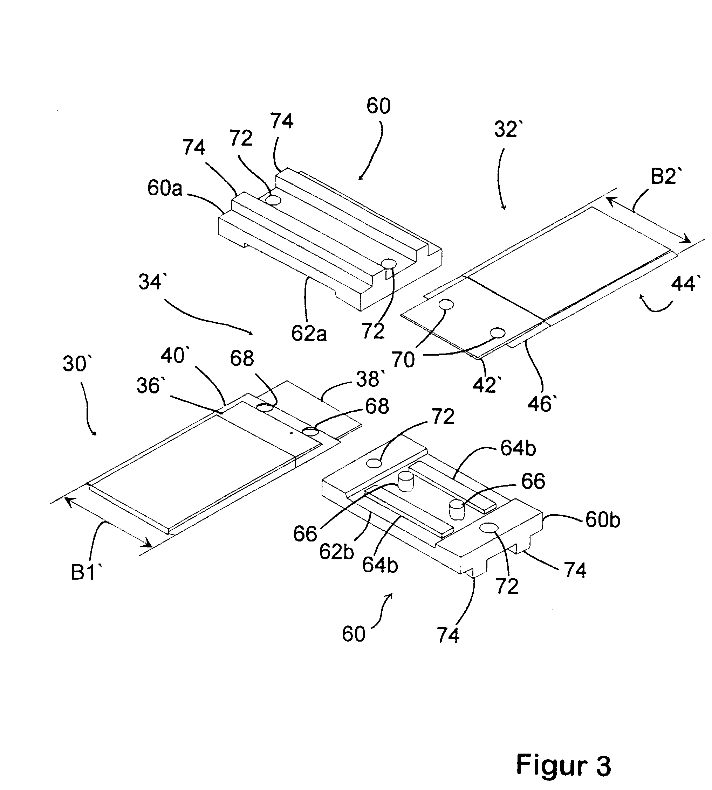

Fig. 3 zeigt ein zweites Ausführungsbeispiel mit einer Anordnung zweier voneinander lösbarer Flachleitungen 30' und 32', die mit Hilfe einer 2-teiligen, aus zwei Hälften 60a und 60b bestehenden Befestigungsschelle 60 miteinander an einer Verbindungsstelle 34' verbunden werden. Die Flachleitung 30' und 32' sind wie die Flachleitungen 30 und 32 aufgebaut, so daß bereits dort erläuterte Bestandteile mit der gleichen Funktion nicht noch einmal erläutert werden, jedoch durch einen hochgestellten Strich gekennzeichnet sind.

Die Isolierstreifen 40' und 46' ragen über die Metallstreifen 36', 38' bzw. die Metallstreifen 42', 44' in Querrichtung der Flachleitung 30' bzw. 32' beidseitig hinaus. Dadurch wird die Isolierwirkung vergrößert und insbesondere werden Kurzschlüsse zwischen den Metallstreifen 36', 38' bzw. 42', 44' durch äußere mechanische Einwirkungen verhindert.

Die Flachleitungen 30' und 32' sind außerhalb der Verbindungsstelle 32' mit einem Kunststoffmaterial überzogen, das ein ungewolltes Berühren verhindert und die Oberfläche der Metallstreifen 36', 38' bzw. 42', 46' schützt.

Die Hälfte 60a bzw. 60b der Befestigungsschelle 60 besteht aus einen isolierenden Kunststoffmaterial und besitzt in Längsrichtung der Flachleitungen 30' und 32' Aussparungen 62a bzw. 62b der Breite B1' bzw. B2' für die Aufnahme der Flachleitungen 30' und 32'. In den Aussparungen 62a bzw. 62b sind aus einem elastischen Material bestehende Beläge 64a bzw. 64b aufgeklebt, die einen gleichmäßigen Andruck der Hälften 60a und 60b an die Flachleitungen 30' und 32' und damit auch einen gleichmäßigen Andruck der Flachleitungen 30' und 32' aneinander sichern. Außerdem befinden sich in der Aussparung 62b Stifte 66, die im montierten Zustand von Durchgangslöchern 68 im Bereich der Anschlußstelle 34' in der Flachleitung 30' und von Durchgangslöchern 70 in der Flachleitung 32' aufgenommen werden. Die Enden der Stifte 66 werden im montierten Zustand von nicht dargestellten Bohrungen im Bereich der Aussparung 62a aufgenommen.

Die Montage der Befestigungsschelle 60 erfolgt, indem nicht dargestellte Schraubverbindungen durch Aufnahmebohrungen 72 in beiden Hälften 60a und 60b der Befestigungsschelle 60 beidseitig der Flachleitung 30' und 32' verschraubt werden. Rippen 74 auf den nach außen weisenden Flächen der Hälften 60a und 60b der Befestigungsschelle 60 dienen der Versteifung.

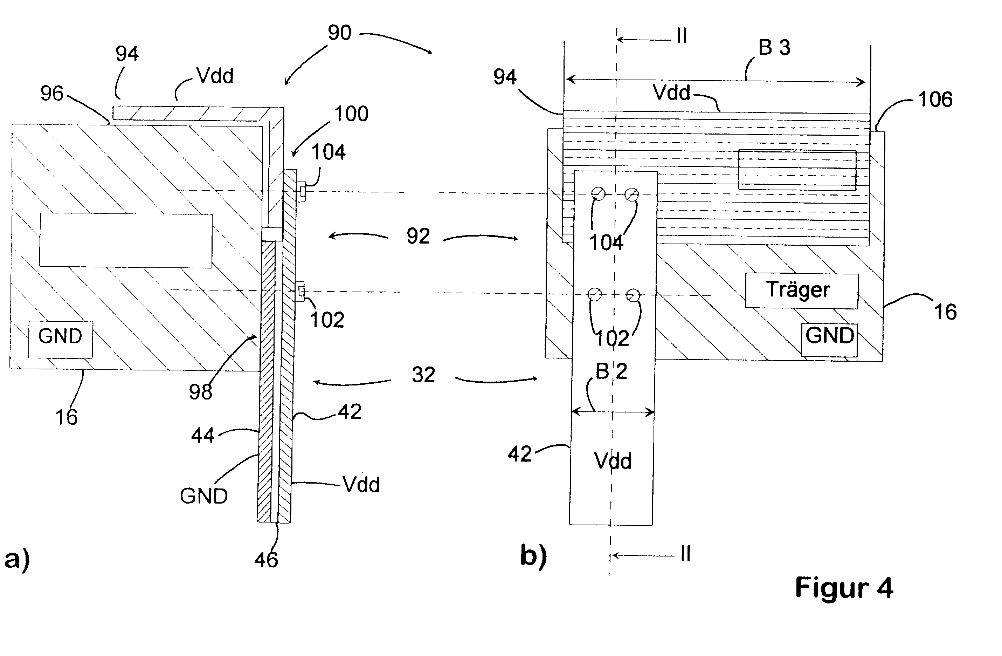

Fig. 4 zeigt ein drittes Ausführungsbeispiel mit einer Anschlußanordnung 90 für die Flachleitung 32 am Träger 16 in einer Schnittdarstellung entlang einer in Teil b der Figur 4 dargestellten Schnittlinie II.

Die Anschlußanordnung 90 wird durch einen Teil der Oberfläche des Trägers 16 gebildet, der mit dem Metallstreifen 44 an einer Verbindungsstelle 92 in flächigem Kontakt steht. Die Anschlußanordnung 90 enthält weiterhin eine an ihrem Ende abgewinkelte Metallelektrode 94 zum Führen des positiven Potentials Vdd vom Metallstreifen 42 zur LED-Belichtungszeile 10. Die Metallelektrode 94 wird durch einen Isolierstreifen 96 in vorgegebenen Abstand bezüglich des Trägers 16 geführt. Dieser Abstand ist klein gewählt, so daß sich eine geringe Induktivität zwischen Träger 16 und Metallelektrode 96 ergibt. An der Verbindungsstelle 92 ragt der Metallstreifen 42 über den Isolator 46 und den Metallstreifen 44 hinaus. Auch der Träger 16 ragt über die Metallelektrode 96 hinaus. Dadurch ist es möglich, daß der Metallstreifen 44 mit dem Träger 16 und der Metallstreifen 42 mit der Metallelektrode 96 überlappend an ebenen Kontaktflächen 98 bzw. 100 in Kontakt gelangen kann. Das Massepotential GND und das positive Potential Vdd werden so im gesamten Bereich der Verbindungsstelle 92 in geringem Abstand voneinander geführt, wodurch auch die Induktivität an der Verbindungsstelle gering ist.

Um den Kontakt auf den Kontaktflächen 98 bzw. 100 zu erhöhen, und um die Flachleitung 32 ortsfest mit dem Träger 16 zu verbinden, sind im Bereich der Verbindungsstelle Schraubverbindungen 102 und 104 vorhanden. Die Schraubverbindung 102 verläuft durch an der Verbindungsstelle 92 angebrachte Bohrungen in dem Metallstreifen 42, dem Isolierstreifen 46 und dem Metallstreifen 44 und endet in einer Bohrung mit Innengewinde im Träger 16. Die Schraubverbindung 104 verläuft durch eine oberhalb der Verbindung 102 im Metallstreifen 42 angeordnete Bohrung, Bohrungen in der Metallelektrode 96 und im Isolierstreifen 94 und endet in einer weiteren Bohrung mit Innengewinde im Träger 16.

Teil b der Figur 4 zeigt die Anschlußanordnung 90 mit der angeschlossenen Flachleitung 32 in einer Draufsicht, in der die Schnittlinie II eingezeichnet ist. Die Metallelektrode 94 hat eine Breite B3, die einen größeren Wert als die Breite B2 der Flachleitung 32 hat. Das Abwinkeln der Metallelektrode 96 an einer Kante 106 des Trägers 16 ermöglicht, die Flachleitung 32 von unten an den Träger 16 heranzuführen, um den vorgegebenen Bauraum im LED-Drucker effektiv zu nutzen.

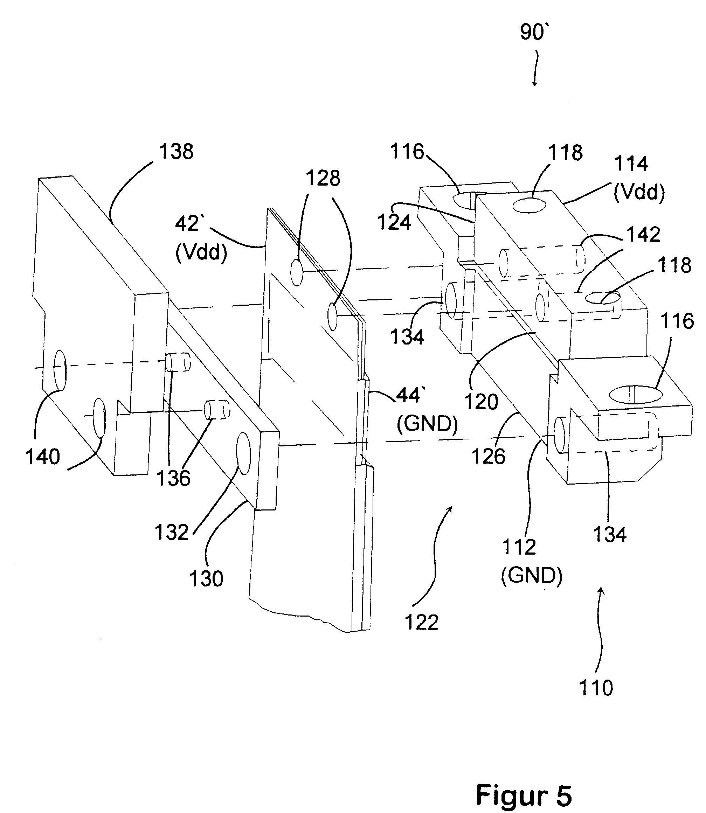

Figur 5 zeigt ein viertes Ausführungsbeispiel mit einer Anschlußanordnung 90' für den Anschluß der Flachleitung 32'. Die Anschlußordnung 90' ist ein Adapter, der aus zwei Anschlußelektroden 112 und 114 besteht. Die Anschlußelektrode 112 wird mit einer Schraubverbindung, die durch Durchgangslöcher 116 verläuft, am Träger 16 angeschraubt. Die Anschlußelektrode 114 wird an einer geräteseitigen Stromschiene zum Führen des positiven Potentials Vdd ebenfalls mit einer Schraubverbindung, die durch Durchgangslöcher 118 mit Innengewinde verläuft, befestigt.

Die beiden Anschlußelektroden 112 und 114 sind voneinander durch einen Luftspalt 120 geringer Dicke voneinander isoliert. Die Anschlußelektrode 114 ragt an einer Verbindungsstelle 122 über die Anschlußelektrode 112 hinaus, so daß eine ebene Kontaktfläche 124 an der Anschlußelektrode 114 gegenüber einer ebenen Kontaktfläche 126 an der Anschlußelektrode 112 eine Abstufung bilden.

Der Anschluß der Flachleitung 32' erfolgt, indem der Metallstreifen 42' auf die Kontaktfläche 124 und der Metallstreifen 44' auf die Kontaktfläche 126 aufgelegt werden. In einem zweiten Schritt wird die Flachleitung 32' befestigt. Die Befestigung erfolgt dabei so, daß nur im Metallstreifen 42' Durchgangsbohrungen 128 vorhanden sein müssen. Dadurch können Maßnahmen bezüglich der Isolierung zwischen den Potentialen Vdd und GND minimiert werden. Eine Befestigungsleiste 130 wird über eine Schraubverbindung, durch Durchgangslöcher 132 in der Befestigungsleiste 130 und Bohrungen mit Innengewinde 134 in der Anschlußelektrode 112 an der Anschlußelektrode 112 befestigt, so daß die Flachleitung 32' bereits in ihrer Lage bezüglich der Anschlußanordnung 90 festgehalten wird. In der Befestigungsleiste 130 befinden sich außerdem Bohrungen 136 mit Innengewinde.

Eine Abdeckplatte 138 enthält Durchgangsbohrungen 140, durch die eine weitere Schraubverbindung geführt wird, die in den Bohrungen 136 endet, wodurch die Abdeckplatte 138 mit der Befestigungsleiste 130 zu einer Einheit verbunden wird. An der Abdeckplatte 138 sind Aussparungen (nicht dargestellt) angeordnet, die Schraubenköpfe von Schrauben aufnehmen, die durch die Durchgangslöcher 128 verlaufen und in Bohrungen 142 mit Innengewinde in der Anschlußelektrode 114 enden, so daß die Flachleitung 32' im montierten Zustand ortsfest mit der Anschlußanordnung 90' verbunden ist, und ein ungewolltes Berühren der Schrauben verhindert ist.

Die Befestigungsleiste 130 ist metallisch und die Abdeckplatte 138 ist aus Kunststoffmaterial gefertigt. Außerdem dient die Abdeckplatte 138 als Berührungsschutz gegen ein ungewolltes Berühren der Potential führenden Bestandteile im Bereich der Verbindungsstelle 122 durch Bedienpersonen.

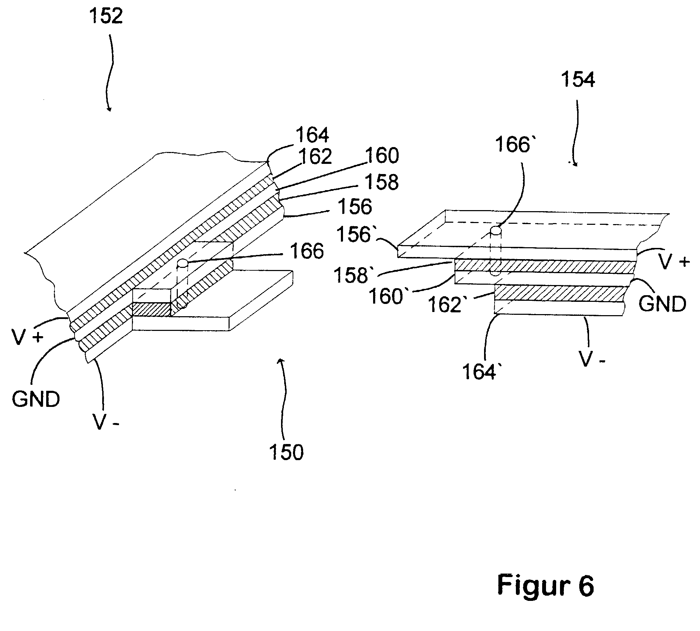

Figur 6 zeigt ein fünftes Ausführungsbeispiel mit zwei an einer Verbindungsstelle 150 voneinander lösbaren Flachleitungen 152 und 154. Die Flachleitung 152 enthält einen ersten Metallstreifen 156, einen über dem ersten Metallstreifen 156 angeordneten Isolierstreifen 158 und einen weiteren Metallstreifen 160. Der Isolierstreifen 158 isoliert den Metallstreifen 160 vom Metallstreifen 156 und ordnet den Metallstreifen 160 zumindest abschnittsweise parallel zum Metallstreifen 156 an. Die Flachleitung 152 enthält außerdem einen weiteren Isolierstreifen 162 und einen dritten Metallstreifen 164, der durch den Isolierstreifen 142 vom darunterliegenden Metallstreifen 160 isoliert und zumindest abschnittsweise parallel zum Metallstreifen 160 angeordnet ist.

Der Metallstreifen 156 führt ein negatives Potential V-, der Metallstreifen 160 führt ein Massepotential GND und der Metallstreifen 164 führt ein positives Potential V+. Die Potentiale V-, GND und V+ werden durch die Strom-/Spannungsversorgung 18 erzeugt.

Im Bereich der Verbindungsstelle 150 verzweigt die Flachleitung 152. Der Metallstreifen 156 ragt über den Isolierstreifen 158 und über den Metallstreifen 160 hinaus. Der Metallstreifen 160 ragt an der Verbindungsstelle 150 über den Isolierstreifen 162 und auch über den Metallstreifen 164 hinaus.

Die Flachleitung 154 hat an der Verzweigungsstelle 150 im wesentlichen den gleichen geometrischen Aufbau wie die Flachleitung 152, so daß bereits erläuterte Bestandteile dasselbe Bezugszeichen, jedoch mit einem hochgestellten Strich, erhalten. In der Flachleitung 154 ist jedoch die Potentialfolge auf den Metallstreifen 156', 160' und 164' umgekehrt zur Potentialfolge auf den Metallstreifen 156, 160 und 164. Somit führt im verbundenen Zustand der Flachleitungen 152 und 154 der Metallstreifen 156' das positive Potential V+, der Metallstreifen 160' das Massepotential GND und der Metallstreifen 164' das negative Potential V-. Die dem positiven Potential V+ zugeordneten Metallstreifen 154 und 156', die dem Massepotential GND zugeordneten Metallstreifen 160 und 160' und die dem negativen Potential V- zugeordneten Metallstreifen 156 und 164' gelangen im verbundenen Zustand der Flachleitungen 152 und 154 jeweils in elektrischen Kontakt, wobei sie sich jeweils unmittelbar überlappen.

Eine durch Durchgangsbohrungen 166 und 166' geführte, nicht dargestellte Schraubverbindung verbindet die Flachleitungen 152 und 154 ortsfest miteinander. Die Durchgangsbohrungen 166 und 166' sind dabei so angeordnet, daß die Stirnflächen einander gegenüberliegender Metallstreifen 158 bis 164 und 158' und 164' sich nicht berühren.

## Patentansprüche

1. Anordnung zum Verbinden zweier voneinander lösbarer Flachleitungen (30, 32; 152, 154),
bei der die erste Flachleitung (30; 152) einen ersten Metallstreifen (38; 156) zur Stromführung und mindestens einen zumindest abschnittsweise parallel zu diesem angeordneten zweiten Metallstreifen (36; 160) zur Stromführung und mindestens einen Isolierstreifen (40; 158) enthält, der zwischen den einander zugewandten breiten Seitenflächen der Metallstreifen (36, 38) einen Abstand festlegt,
die erste Flachleitung (30; 152) an der Verbindungsstelle (34; 150) mit der zweiten Flachleitung (32; 154) derart ausgebildet ist, daß der erste Metallstreifen (38; 156) im wesentlichen in seiner gesamten Breite über den Isolierstreifen (40; 158) hinausragt,
die zweite Flachleitung (32; 154) zumindest an der Verbindungsstelle (34; 150) im wesentlichen den gleichen geometrischen Aufbau wie die erste Flachleitung (30; 152) hat,
und bei der an der Verbindungsstelle (34; 150) zumindest der erste Metallstreifen (38; 156) der ersten Flachleitung (30; 152) mit dem weiteren Metallstreifen (44; 164) der zweiten Flachleitung (32; 154) und der weitere Metallstreifen (36; 160) der ersten Flachleitung (30; 152) mit dem ersten Metallstreifen (42; 160) der zweiten Flachleitung (32; 154) in elektrischen Kontakt gelangen,
dadurch **gekennzeichnet**, daß die Flachleitungen (30, 32; 152, 154) eine elektrische Verbindung (20) zwischen einer Stromversorgung (18) und einer Belichtungsvorrichtung (10) in einem elektrografischen LED-Drucker oder LED-Kopiergerät zum Übertragen von Stromimpulsen niedriger Spannung für die LEDs herstellen,
und daß die erste Flachleitung unmittelbar mit der Stromversorgung (18) und die zweite Flachleitung unmittelbar mit der Belichtungsvorrichtung (10) und miteinander an der einzigen Verbindungsstelle (34; 150) verbunden sind.

2. Anordnung nach Anspruch 1, dadurch gekennzeichnet, daß die in Kontakt stehenden Metallstreifen (36, 42; 38, 44) sich überlappen.

3. Anordnung nach einem der vorhergehenden Ansprüche, dadurch gekennzeichnet, daß jede der Flachleitungen (30, 32) an der Verbindungsstelle (34) mindestens eine Aufnahme für eine Verbindungsvorrichtung (48, 60) enthält.

4. Anordnung nach Anspruch 3, dadurch gekennzeichnet, daß die Verbindungsvorrichtung (60) die beiden Flachleitungen (30', 32') an der Verbindungsstelle (34') nach Art einer Schelle umfaßt.

5. Anordnung nach Anspruch 3 oder 4, dadurch gekennzeichnet, daß die Verbindungsvorrichtung (48, 60) mindestens eine Schraubverbindung enthält.

6. Anordnung nach einem der Ansprüche 3 bis 5, dadurch gekennzeichnet, daß die Aufnahme ein Durchgangsloch (68, 70) ist.

7. Anordnung nach Anspruch 6, dadurch gekennzeichnet, daß zumindest zwei der Durchgangslöcher (68, 70) einander auf einer Lochachse gegenüberliegen.

8. Anordnung nach Anspruch 5 und 7, dadurch gekennzeichnet, daß die Schraubverbindung in mindestens einem Durchgangsloch (72) aufgenommen wird.

9. Anordnung nach Anspruch 6 oder 7, dadurch gekennzeichnet, daß die Verbindungsvorrichtung mindestens einen Stift (66) enthält, der durch mindestens ein Durchgangsloch (68, 70) geführt wird.

10. Anordnung nach Anspruch 9, dadurch gekennzeichnet, daß der Stift (66) und/oder zumindest ein Teil der Verbindungsvorrichtung (60) aus Kunststoffmaterial bestehen.

11. Anschlußanordnung (90) für den Anschluß einer mit einem ersten elektrischen Bauteil (10) verbundenen Flachleitung (32) an ein zweites elektrisches Bauteil (18) in einem elektrografischen Drucker oder Kopiergerät insbesondere an eine Stromversorgung (18) oder eine LED-Belichtungsvorrichtung (10),
wobei die Flachleitung (32) einen ersten Metallstreifen (42) zur Stromführung und mindestens einen zumindest abschnittsweise parallel zu diesem angeordneten zweiten Metallstreifen (44) zur Stromführung und einen Isolierstreifen (46) enthält, der zwischen den einander zugewandten breiten Seitenflächen der Metallstreifen (42, 44) einen Abstand festlegt,
und wobei die Flachleitung (32) an ihrer Anschlußstelle mit dem Gerät derart ausgebildet ist, daß der erste Metallstreifen (42) im wesentlichen in seiner gesamten Breite über den Isolierstreifen (46) hinausragt,
mit einer am Gerät fest angeordneten ersten Anschlußelektrode (16) mit einer ebenen Kontaktfläche zur Stromführung und mindestens einer zweiten Anschlußelektrode (94)
mit einer zumindest abschnittsweise parallel zur ebenen Kontaktfläche angeordneten weiteren ebenen Kontaktfläche zur Stromführung und mit mindestens einem weiteren Isolierstreifen (96), der die weitere Anschlußelektrode (94) von der ersten Anschlußelektrode (98) isoliert,
wobei die erste Anschlußelektrode (98) an der Verbindungsstelle (92) über den weiteren Isolierstreifen (96) hinausragt,
und bei der an der Verbindungsstelle (92) zumindest der erste Metallstreifen (42) mit der weiteren Anschlußelektrode (94) und der weitere Metallstreifen (44) mit der ersten Anschlußelektrode (16) in elektrischen Kontakt gelangen.

12. Anschlußanordnung für den Anschluß einer mit einem ersten elektrischen Bauteil (10) verbundenen Flachleitung (32') an ein zweites elektrisches Bauteil (18) in einem elektrografischen Drucker oder Kopiergerät insbesondere an eine Stromversorgung (18) oder eine LED-Belichtungsvorrichtung (10),
wobei die Flachleitung (32') einen ersten Metallstreifen (42') zur Stromführung und mindestens einen zumindest abschnittsweise parallel zu diesem angeordneten zweiten Metallstreifen (44') zur Stromführung und einen Isolierstreifen (46') enthält, der zwischen den einander zugewandten breiten Seitenflächen der Metallstreifen (42', 44') einen Abstand festlegt,
und wobei die Flachleitung (32') an ihrer Anschlußstelle mit dem Gerät derart ausgebildet ist, daß der erste Metallstreifen (42') im wesentlichen in seiner gesamten Breite über den Isolierstreifen (46') hinausragt,
mit einer am Gerät fest angeordneten ersten Anschlußelektrode (114) mit einer ebenen Kontaktfläche zur Stromführung und mindestens einer durch einen Isolator (120) von der ersten Anschlußelektrode (114) getrennten zweiten Anschlußelektrode (112) mit einer weiteren ebenen Kontaktfläche zur Stromführung,
wobei die erste Anschlußelektrode (114) an der Verbindungsstelle (122) über die weitere Anschlußelektrode (112) hinausragt,
und bei der an der Verbindungsstelle (122) zumindest der erste Metallstreifen (42') mit der ersten Anschlußelektrode (114) und der weitere Metallstreifen (46') mit der weiteren Anschlußelektrode (112) in elektrischen Kontakt gelangen.

13. Anschlußanordnung nach Anspruch 11 oder 12, dadurch gekennzeichnet, daß an der Verbindungsstelle (90, 90') mindestens eine Aufnahme (134, 142) für ein Befestigungselement (130, 138) vorhanden ist.

14. Anschlußanordnung nach Anspruch 11 oder 12, dadurch gekennzeichnet, daß die Aufnahme (134) eine Bohrung ist, die vorzugsweise ein Innengewinde hat.

## Claims

1. Arrangement for connecting two mutually detachable flat cables (30, 32; 152, 154),
in which the first flat cable (30; 152) includes a first metal strip (38; 156) for conducting current and at least one second metal strip (36; 160) for conducting current, which is arranged at least in sections parallel to this first metal strip, and at least one insulating strip (40; 158) which fixes a spacing between the mutually facing broad side faces of the metal strips (36; 38),
the first flat cable (30; 152) is constructed at the connecting point (34; 150) to the second flat cable (32; 154) in such a way that the first metal strip (38; 156) essentially projects with its entire width beyond the insulating strip (40; 158),
at least at the connecting point (34; 150) the second flat cable (32; 154) has substantially the same geometrical design as the first flat cable (30; 152), and in which at the connecting point (34; 150) at least the first metal strip (38; 156) of the first flat cable (30; 152) comes into electric contact with the further metal strip (44; 164) of the second flat cable (32; 154), and the further metal strip (36; 160) of the first flat cable (30; 152) comes into electric contact with the first metal strip (42; 160) of the second flat cable (32; 154),
characterized in that the flat cables (30, 32; 152, 154) produce an electric connection (20) between a power supply (18) and an exposure device (10) in an electrographic LED printer or LED copier for transmitting current pulses of low voltage for the LED(s),
and in that the first flat cable is connected directly to the power supply (18), and the second flat cable is connected directly to the exposure device (10), and the two flat cables are interconnected at the single connecting point (34; 150).

2. Arrangement according to Claim 1, characterized in that the metal strips (36, 42; 38, 44), which are contact, overlap one another.

3. Arrangement according to one of the preceding claims, characterized in that each of the flat cables (30, 32) includes at the connecting point (34) at least one receptacle for a connecting device (48, 60).

4. Arrangement according to Claim 3, characterized in that the connecting device (60) grips the two flat cables (30', 32') at the connecting point (34') in the manner of a clip.

5. Arrangement according to Claim 3 or 4, characterized in that the connecting device (48, 60) includes at least one screwed connection.

6. Arrangement according to one of Claims 3 to 5, characterized in that the receptacle is a through-hole (68, 70).

7. Arrangement according to Claim 6, characterized in that at least two of the through holes (68, 70) are situated opposite one another on a hole access.

8. Arrangement according to Claims 5 and 7, characterized in that the screwed connection is held in at least one through hole (72).

9. Arrangement according to Claim 6 or 7, characterized in that the connecting device includes at least one pin (66) which is guided through at least one through-hole (68, 70).

10. Arrangement according to Claim 9, characterized in that the pin (66) and/or at least a part of the connecting device (60) consist of plastic material.

11. Connecting arrangement (90) for connecting a flat cable (32), connected to a first electric component (10), to a second electric component (18) in an electrographic printer or copier, in particular to a power supply (18) or an LED exposure device (10),
the flat cable (32) including a first metal strip (42) for conducting currents, and at least a second metal strip (44) for conducting current, which is arranged at least in sections parallel to this first metal strip, and an insulating strip (46) which fixes a spacing between the mutually facing broad side faces of the metal strips (42, 44),
and the flat cable (32) being constructed at its connecting point with the device in such a way that the first metal strip (42) essentially projects with its entire width beyond the insulating strip (46),
having a first connecting electrode (16), which is permanently arranged on the dence and has a flat contact surface for conducting current and at least a second connecting electrode (94) having a further flat contact surface for conducting current, which is arranged at least in sections parallel to the flat contact surface, and having at least one further insulating strip (96) which insulates the further connecting electrode (94) from the first connecting electrode (98),
the first connecting electrode (98) projecting at the connecting point (92) beyond the further insulating strip (96),
and in which at the connecting point (92) at least the first metal strip (42) comes into electric contact with the further connecting electrode (94), and the further metal strip (44) comes into electric contact with the first connecting electrode (16) .

12. Connecting arrangement for connecting a flat cable (32'), connected to a first electric component (10), to a second electric component (18) in an electrographic printer or copier, in particular to a power supply (18) or an LED exposure device (10),
the flat cable (32') including a first metal strip (42') for conducting currents, and at least a second metal strip (44') for conducting current, which is arranged at least in sections parallel to this first metal strip, and an insulating strip (46') which fixes a spacing between the mutually facing broad side faces of the metal strips (42, 44),
and the flat cable (32') being constructed at its connecting point with the device in such a way that the first metal strip (42') essentially projects with its entire width beyond the insulating strip (46'),
having a first connecting electrode (114), which is permanently arranged on the device and has a flat contact surface for conducting current and at least a second connecting electrode (112), which is separated by an insulator (120) from the first connecting electrode (114) and has a further flat contact surface for conducting current,
the first connecting electrode (114) projecting at the connecting point (122) beyond the further connecting electrode (112),
and in which at the connecting point (122) at least the first metal strip (42') comes into electric contact with the first connecting electrode (114), and the further metal strip (46') comes into electric contact with the further connecting electrode (112).

13. Connecting arrangement according to Claim 11 or 12, characterized in that at least one receptacle (134, 142) for a fastening element (130, 138) is present at the connecting point (90, 90').

14. Connecting arrangement according to Claim 11 or 12, characterized in that the receptacle (134) is a bore which preferably has an internal thread.

## Revendications

1. Dispositif pour connecter deux conducteurs plats (30, 32 ; 152, 154) qui peuvent être séparés l'un de l'autre, dans lequel le premier conducteur plat (30 ; 152) comprend une première bande métallique (38 ; 156) pour le passage du courant et au moins une deuxième bande métallique (36; 160), pour le passage du courant, disposée parallèlement à la première, au moins par segments, et au moins une bande isolante (40 ; 158) qui établit un espacement entre les surfaces latérales larges des bandes métalliques (36, 38) qui sont dirigées l'une vers l'autre,
le premier conducteur plat (30 ; 152) est configuré, dans la zone de connexion (34 ; 150) avec le deuxième conducteur plat (32 ; 154), de manière que la première bande métallique (38 ; 156) déborde sensiblement sur tcute sa largeur au-delà de la bande isolante (40 ; 158),
le deuxième conducteur plat (32 ; 154) possède, au moins dans la zone de connexion (34 ; 150), sensiblement la même construction géométrique que le premier conducteur plat (30 ; 152),
et dans lequel, dans la zone de connexion (34 ; 150), au moins la première bande métallique (38 ; 156) du premier conducteur plat (30 ; 152) vient en contact électrique avec l'autre bande métallique (44 ; 164) du deuxième conducteur plat (32 ; 154), et l'autre bande métallique (36 ; 160) du premier conducteur plat (30 ; 152) vient en contact électrique avec la première bande métallique (42 ; 160) du deuxième conducteur plat ( 32 ; 154),
caractérisé en ce que les conducteurs plats (30, 32 ; 152, 154) établissent une connexicn électrique (20) entre une alimentation électrique (18) et un dispositif d'éclairage (10) dans une imprimante électrographique ou un copieur à LED, pour transmettre des impulsions de courant de basse tension destinées aux LED,
et en ce que le premier conducteur plat est directement connecté à l'alimentation électrique (18) et le deuxième conducteur plat est directement connecté au dispositif d'éclairage (10), et ces conducteurs sont connectés l'un à l'autre dans l'unique zone de connexion (34 ; 150).

2. Dispositif selon la revendication 1, caractérisé en ce que les bandes métalliques (36, 42 ; 38, 44) qui sont en contact se recouvrent mutuellement.

3. Dispositif selon une des revendications précédentes, caractérisé en ce que chacun des conducteurs plats (30, 32) renferme dans la zone de connexion (34) au moins un logement pour un dispositif de connexion (48, 60).

4. Dispositif selon la revendication 3, caractérisé en ce que le dispositif de connexion (60) entoure les deux conducteurs plats (30', 32') dans la zone de connexion (34') à la façon d'un collier.

5. Dispositif selon la revendication 3 ou 4, caractérisé en ce que le dispositif de connexion (48, 60) comprend au moins une liaison par boulons.

6. Dispositif selon une des revendications 3 à 5, caractérisé en ce que le logement est constitué par un trou traversant (68, 70).

7. Dispositif selon la revendication 6, caractérisé en ce qu'au moins deux des trous traversants (68, 70) sont l'un en regard de l'autre sur un axe des trous.

8. Dispositif selon les revendications 5 et 7, caractérisé en ce que la liaison par boulons est logée dans au moins un trou traversant (72).

9. Dispositif selon la revendication 6 ou 7, caractérisé en ce que le dispositif de connexion comprend au moins une cheville (66) qui est passée à travers au moins un trou traversant (68, 70).

10. Dispositif selon la revendication 9, caractérisé en ce que la cheville (66) et/ou au moins une partie du dispositif de connexion (60) sont en matière plastique.

11. Dispositif de raccordement (90) pour raccorder un conducteur plat (32) connecté à un premier composant électrique (10), à un deuxième composant électrique (18) inclus dans une imprimante ou un copieur électrographique, en particulier à une alimentation électrique (18) ou à un dispositif d'éclairage à LED (10),
dans lequel le conducteur plat (32) comprend une première bande métallique (42) pour le passage du courant et au moins une deuxième bande métallique (44) pour le passage du courant, disposée parallèlement à la première, au moins par segments, ainsi qu'une bande isolante (46) qui établit un espacement entre les surfaces latérales larges des bandes métalliques (42, 44) qui sont dirigées l'une vers l'autre,
et dans lequel le conducteur plat (32) est configuré, dans sa zone de raccordement à l'appareil, de manière que la première bande métallique (42) déborde sensiblement sur toute sa largeur au-delà de la bande isolante (46),
comprenant une première électrode de raccordement (16) agencée solidairement sur l'appareil et présentant une surface de contact plane pour le passage du courant, et au moins une deuxième électrode de raccordement (94) qui présente une autre surface de contact plane pour le passage du courant, disposée parallèlement à la surface de contact plane, au moins par segments, et au moins une autre bande isolante (96) qui isole l'autre électrode de raccordement (94) de la première électrode de raccordement (98),
la première électrode de raccordement (98) déborde au-delà de l'autre bande isolante (96) dans la zone de connexion (92),
et dans lequel, dans la zone de connexion (92), au moins la première bande métallique (42) vient en contact électrique avec l'autre électrode de raccordement (94), et l'autre bande métallique (44) vient en contact électrique avec la première électrode de raccordement (16).

12. Dispositif de raccordement pour le raccordement d'un conducteur plat (32') connecté à un premier composant électrique (10) à un deuxième composant électrique (18) dans une imprimante ou un copieur électrographique, en particulier à une alimentation électrique (18) ou à un dispositif d'éclairage à LED (10),
dans lequel le conducteur plat (32') renferme une première bande métallique (42') pour le passage du courant et au moins une deuxième bande métallique (44') pour le passage du courant disposée parallèlement à la première, au moins par segments, ainsi qu'une bande isolante (46') qui établit un espacement entre les surfaces latérales larges des bandes métalliques (42', 44') qui sont dirigées l'une vers l'autre,
et dans lequel le conducteur plat (32') est configuré, dans sa zone de raccordement à l'appareil, de manière que la première bande métallique (42') déborde sensiblement sur toute sa largeur au-delà de la bande isolante (46'),
comprenant une première électrode de raccordement (114) agencée solidairement sur l'appareil et présentant une surface de contact plane pour le passage du courant, et au moins une deuxième électrode de raccordement (112) séparée de la première électrode de raccordement (114) par un isolateur (120) et présentant une autre surface de contact plane pour le passage du courant,
la première électrode de raccordement (114) débordant au-delà de l'autre électrode de raccordement (112) dans la zone de connexion (122),
et dans lequel, dans la zone de connexion (122), au moins la première bande métallique (42') vient contact électrique avec la première électrode de raccordement (114) , et l'autre bande métallique (46') vient en contact électrique avec l'autre électrode de raccordement (112).

13. Dispositif de raccordement selon la revendication 11 ou 12, caractérisé en ce que, dans la zone de connexion (90, 90'), il est prévu au moins un logement (134, 142) pour un élément de fixation (130, 138).

14. Dispositif de raccordement selon la revendication 11 ou 12, caractérisé en ce que le logement (134) est un perçage qui présente de préférence un filetage intérieur.
